# EUROPÄISCHE PATENTSCHRIFT

(11) **EP 0 927 456 B1**
(45) Veröffentlichungstag und Bekanntmachung des Hinweises auf die Patenterteilung: **18.07.2001**
(21) Anmeldenummer: 97941844.9
(22) Anmeldetag: 28.08.1997
(51) Int. Cl.: H03H 9/64, H03H 9/02

(54) **TWIN-DUALMODE-FILTER**
TWIN DUALMODE FILTERS
FILTRES JUMELES DU TYPE BIMODE

(30) Priorität: 19.09.1996 DE 19638455
(43) Veröffentlichungstag der Anmeldung: 07.07.1999
(73) Patentinhaber: EPCOS AG, 81541 München (DE)
(72) Erfinder: BAIER, Thomas, D-81539 München (DE)
(74) Vertreter: Epping, Wilhelm, Dipl.-Ing.
(86) Internationale Anmeldenummer: DE9701878
(87) Internationale Veröffentlichungsnummer: WO9812807

(56) Entgegenhaltungen:
- EP-A- 0 545 672
- DE-A- 4 227 362
- DE-C- 4 439 489
- JP-A- 6 334 475

## Beschreibung

Die vorliegende Erfindung betrifft ein Twin-Dualmode-Filter nach dem Oberbegriff des Patentanspruchs 1.

Aus der EP-0545672 A1 ist ein Oberflächenwellenfilter bekannt, bei dem zwei akustische Spuren mit unidirektionalen Ein- und Ausgangswandlern parallel verschaltet sind. Aus der DE-4439489 C1 ist ein transversalmoden-gekoppeltes Resonatorfilter bekannt, bei dem zwei Transversalmodenresonatorfiltereinheiten, die jeweils mehrere akustisch und elektrisch gekoppelte Resonatoren umfassen, kaskadierend in Serie geschaltet sind. Aus der DE-4227362 A1 ist ebenfalls ein kaskadiertes Resonatorfilter (TMR-Filter) bekannt, bei dem zwei TMR-Filterspuren in Serie geschaltet sind.

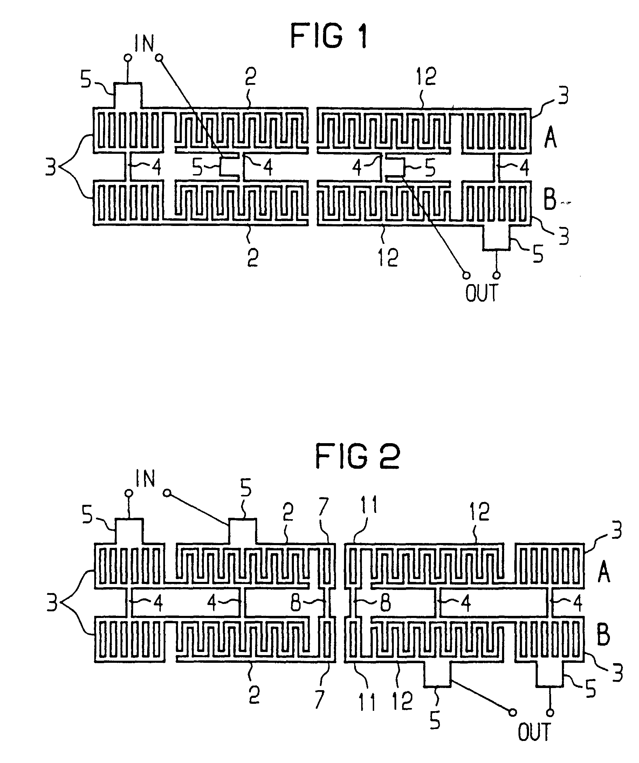

Longitudinalmodenresonatorfilter, auch Dualmode-Filter oder DMS -Filter genannt, sind im folgenden als OFW-Filter bezeichnete Oberflächenwellenfilter, die zwei gemäß der schematischen Aufsicht nach Fig. 1 innerhalb von Reflektoren 3, 3 angeordnete und als Ein- bzw. Ausgangswandler 2, 12 wirksame Normalfingerwandler aufweisen. Sie besitzen eine Zweipolfiltercharakteristik. Verschaltet man, wie dies in Fig. 1 gezeigt ist, zwei DMS-Spuren A und B, die derart gegeneinander frequenzverschoben sind, daß die hochfrequente Resonanz der niederfrequenten Spur B auf die niederfrequente Resonanz der hochfrequenten Spur A fällt, so erhält man ein sogenanntes Twin-Dualmode-Filter, das sich durch eine dreipolige Filtercharakteristik und durch eine gegenüber der Einzelspur erhöhte Flankensteilheit auszeichnet.

Bei der Filterstruktur gemäß Fig. 1, die in ähnlicher Form aus der japanischen Anmeldung JP-A-6334475 bekannt ist, muß auf seiten des Filtereingangs und Filterausgangs IN bzw. OUT jeweils ein Bonddraht mindestens über eine Anschlußleitung, im ungünstigsten Fall über eine der DMS-Spuren A, B hinweg geführt werden. Dies erfordert zusätzlich Chip- bzw. Substratfläche für die über Leiterbahnen 4 mit den Wandlern 2, 12 verbundenen Bondpads 5 zwischen den DMS-Spuren A, B und kompliziert die Fertigung eines solchen Filters.

Nachteilig ist ferner, daß die Impedanzen des Filters durch Vergrößerung der Apertur nicht beliebig verkleinert werden können, da in diesem Fall störende transversale Moden auftreten.

Darüber hinaus wird bei symetrischem Betrieb des Twin-Dualmode-Filter keine optimale Unterdrückung des elektrischen Übersprechens erreicht, da die Geometrie nicht symmetrisch ist.

Sind die DMS-Spuren bezüglich der Resonanzfrequenzen nicht optimal zueinander justiert, so kommt es zu erhöhten Amplituden- und Gruppenlaufzeitverzerrungen im Filterdurchlaßbereich. Eine solche Dejustierung ist in der Serienfertigung aufgrund der Streuungen der Fertigungsparameter und der Inhomogenitäten auf dem Wafer unvermeidlich.

Der vorliegenden Erfindung liegt die Aufgabe zugrunde, ein Twin-Dualmode-Filter gemäß der eingangs genannten Art anzugeben, bei dem zumindest das erstgenannte Problem gelöst, d.h. ein kreuzungsfreies Layout für die Bonddrähte geschaffen ist.

Diese Aufgabe wird bei einem Twin-Dualmode-Filter der eingangs genannten Art erfindungsgemäß durch die Maßnahmen des Patentanspruchs 1 gelöst.

Zusätzliche Maßnahmen, durch welche erforderlichenfalls die weiteren vorstehend aufgeführten Probleme lösbar sind, sind Gegenstand von Unteransprüchen.

Die Erfindung wird nachfolgend anhand von Ausführungsbeispielen gemäß den Figuren der Zeichnung näher erläutert.

Es zeigt:
- Figur 2: eine Ausführungsform eines erfindungsgemäßen Twin-Dualmode-Filters in schematischer Aufsicht;
- Figuren 3 - 6: weitere Ausführungsformen erfindungsgemäßer Twin-Dualmode-Filter in der Darstellung nach Fig. 2.

Gleiche Elemente in den Figuren sind dabei mit gleichen Bezugszeichen bezeichnet.

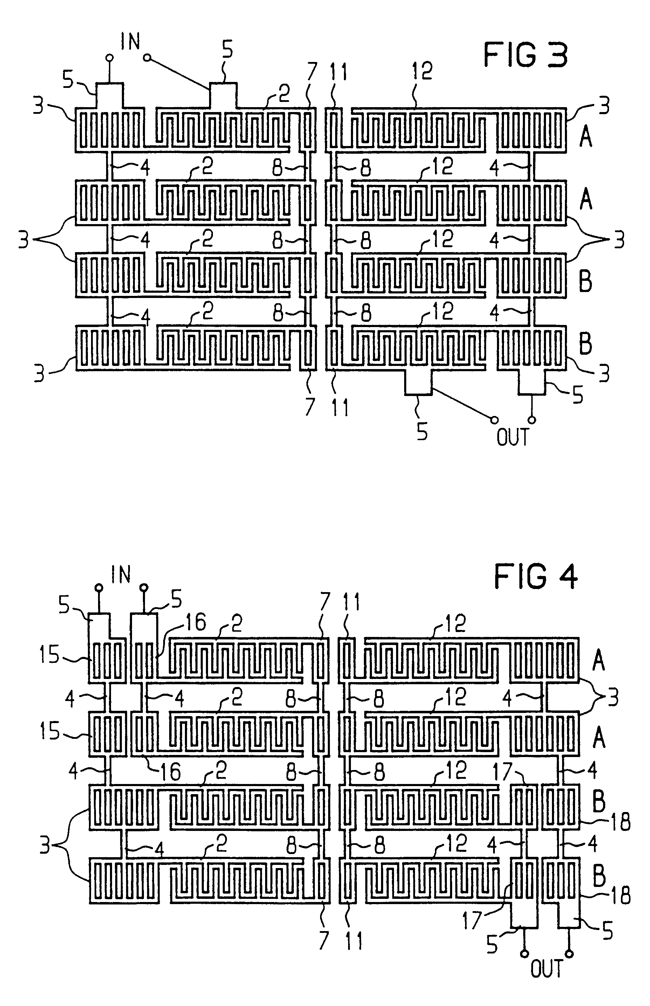

Fig. 2 zeigt ein Twin-Dualmode-Filter, das zwei über Leiterbahnen 4 verschaltete DMS-Filter besitzt, die je DMS-Spur A, B zwei als Ein- bzw. Ausgangswandler 2 bzw. 12 wirksame Normalfingerwandler innerhalb von Reflektoren 3, 3 aufweisen. Die DMS-Spuren A und B sind gegeneinander frequenzverschoben, derart daß die hochfrequente Resonanz der niederfrequenten Spur B auf die niederfrequente Resonanz der hochfrequenten Spur A fällt. Zwischen Ein- und Ausgangswandler 2 bzw. 12 jeder DMS-Spur A bzw. B sind geeignete kurze Reflektoren 7, 11 angeordnet, die jeweils mit einem der Wandler 2 bzw. 12 verschaltet sind. Die Reflektoren der Ein- und Ausgangsseite sind ferner jeweils über Leiterbahnen 4, 8 miteinander elektrisch verbunden.

Durch diese Reflektoren und ihre Verschaltung miteinander können die Bondpads 5 auf die Außenseite der Filterstruktur verlegt und damit ein kreuzungsfreies Layout erhalten werden.

Die Reflektoren 7, 11 können sowohl bei dieser als auch sämtlichen weiteren Ausführungsformen nach der Erfindung durch Finger geeigneter Breite ersetzt sein.

Ohne das Auftreten störender transfersaler Moden lassen sich durch Parallelschaltung mehrerer DMS-Spurenpaare A, B niedrige Impedanzen erreichen. So erhält man z.B. durch Parallelschaltung zweier Twin-Dualmode-Filter gemäß Fig. 3 eine Halbierung der Impedanz.

Eine Symmetrierung der Filtergeometrie wie sie bei symmetrischem Betrieb zur optimalen Unterdrückung des elektrischen Übersprechens erforderlich ist, wird gemäß Fig. 4 z.B. durch Serienschaltung von zwei Twin-Dualmode-Filter erreicht. Die eingangseitigen Reflektoren 3 der DMS-Spuren A und die ausgangsseitigen Reflektoren 3 der DMS-Spuren B gemäß Fig. 3 sind dabei in galvanisch entkoppelte Reflektoren 15, 16 bzw. 17, 18 aufgetrennt.

Durch die Serienschaltung wird zusätzlich eine Verdoppelung der Eingangsimpedanz bei gleichzeitiger Halbierung der statischen Filterkapazität erzielt. Dieses Filter ist im übrigen auch unsymmetrisch betreibbar.

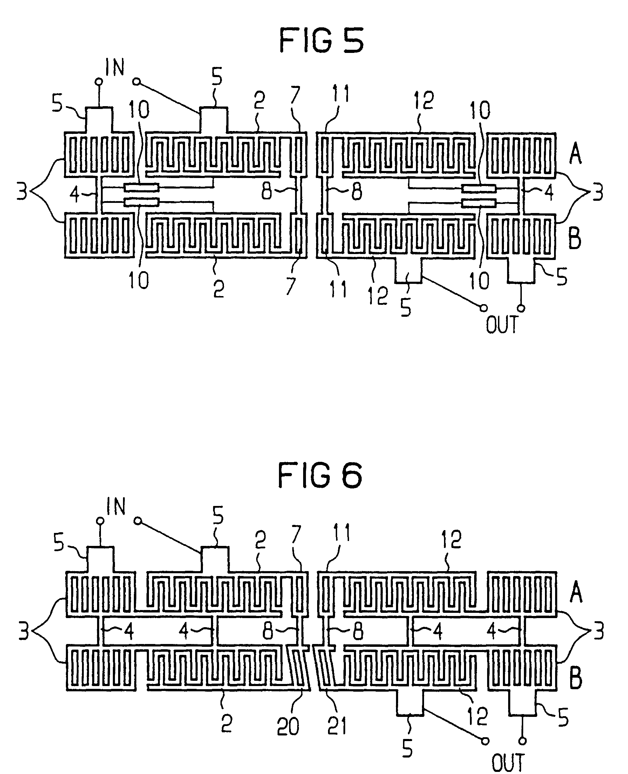

Die bereits angesprochenen, durch Dejustierung der DMS-Spuren A, B verursachten, erhöhten Gruppenlaufzeitverzerrungen im Filterdurchlaßbereich werden durch Wechselwirkung der nahezu identischen Resonanzen beider DMS-Spuren A, B hervorgerufen. Verringert man die Güten der Resonanzen, so können diese Resonanzeffekte abgeschwächt werden. Unter Inkaufnahme einer Erhöhung der Einfügungsdampfung können gemäß Fig. 5 die Güten z.B. dadurch verschlechtert werden, daß in die Zuleitungen zu den Ein- und Ausgangswandlern 2 bzw. 12 ohmsche Widerstände 10 geschaltet sind.

Bei Twin-Dualmode-Filtern besitzt die hochfrequente Resonanz konstruktionsbedingt eine deutlich höhere Güte als die niederfrequente. Man kann die Gruppenlaufzeitverzerrungen bei Fehljustierungen im Twin-Dualmode-Filter auch dadurch verringern, daß man gezielt die Güte der hochfrequenten Resonanz der niederfrequenten DMS-Spur B verringert. Dies kann wie in Fig. 6 gezeigt ist erfindungsgemäß dadurch erreicht werden, daß zwischen Ein- und Ausgangswandler 2 bzw. 12 der niederfrequenten DMS-Spur B zwei jeweils mit einem dieser Wandler verschaltete Reflektoren 20, 21 mit zur Ausbreitungsrichtung der Oberflächenwellen geneigten bzw. schräg gestellten Fingern angeordnet sind. Durch ihre Schrägstellung wird ein kleiner Teil, der diese Reflektoren durchlaufenden akustischen Leistung aus der akustischen Spur heraus, z.B. in einen Wellensumpf hineinreflektiert

Die niederfrequente Resonanz entsteht im Eingangswandler 2. Die akustische Welle durchläuft die schräggestellten Reflektoren nur einmal, wobei sie nur schwach bedämpft wird. Hingegen wird bei der hochfrequenten Resonanz die akustische Welle sehr oft zwischen Ein- und Augangswandler 2 bzw. 12 hin- und herreflektiert, d. h. daß sie die Reflektoren 20, 21 sehr oft durchläuft und dadurch stark bedämpft wird.

## Patentansprüche

1. Twin-Dualmode-Filter, aufweisend zwei über Leiterbahnen (4) verschaltete DMS-Filter mit je DMS-Spur (A, B) zwei als Ein- bzw. Ausgangswandler wirksamen Normalfingerwandlern (2, 12) innerhalb von Reflektoren (3), wobei die DMS-Spuren gegeneinander frequenzverschoben sind derart, daß die hochfrequente Resonanz der niederfrequenten Spur auf die niederfrequente Resonanz der hochfrequenten Spur fällt,
**dadurch gekennzeichnet,**
daß zwischen Ein- und Ausgangswandler (2, 12) jeder DMS-Spur (A, B) zwei kurze jeweils mit einem der Wandler verschaltete Reflektoren (7, 11) angeordnet sind, wobei jeweils die Reflektoren (3, 7, 11) der Ein- bzw. Ausgangsseite über Leiterbahnen (4, 8, 8) miteinander elektrisch verbunden sind.

2. Twin-Dualmode-Filter nach Anspruch 1,
**dadurch gekennzeichnet,**
daß die kurzen Reflektoren (7, 11) durch Finger geeigneter Breite ersetzt sind.

3. Twin-Dualmode-Filter nach Anspruch 1 oder 2,
**dadurch gekennzeichnet,**
daß zwei Twin-Dualmode-Filter parallelgeschaltet sind.

4. Twin-Dualmode-Filter nach Anspruch 1 oder 2,
**gekennzeichnet durch**
zwei Twin-Dualmode-Filter mit in Serie geschalteten Ausgängen.

5. Twin-Dualmode-Filter nach Anspruch 1 oder 2,
**gekennzeichnet durch**
zwei Twin-Dualmode-Filter mit in Serie geschalteten Eingängen und parallel geschalteten Ausgängen.

6. Twin-Dualmode-Filter nach Anspruch 1 bis 5,
**dadurch gekennzeichnet,**
daß in die Zuleitungen zu den Ein- und Ausgangswandlern (2 bzw. 12) ohmsche Widerstände (10) geschaltet sind.

7. Twin-Dualmode-Filter nach Anspruch 1 bis 6,
**dadurch gekennzeichnet,**
daß die zwei zwischen Ein- und Ausgangswandler (2, 12) der niederfrequenten DMS-Spur (B) angeordneten und jeweils mit einem der Wandler (2 bzw. 12) verschalteten Reflektoren (20, 21) mit zur Ausbreitungsrichtung der Oberflächenwellen geneigten Fingern ausgebildet sind.

8. Twin-Dualmode-Filter nach Anspruch 1 bis 7,
**dadurch gekennzeichnet,**
daß die Anschlußelemente (5) des Filtereingangs und Filterausgangs auf die voneinander abgekehrten Substratflächen der DMS-Spuren (A, B) kreuzungsfrei aufgebracht sind.

## Claims

1. Twin dual-mode filter having two DMS filters which are connected via conductor tracks (4) and have [lacuna] DMS track (A, B) each two normal finger converters (2, 12), acting as input and output converter, respectively, inside reflectors (3), the DMS tracks being mutually frequency-shifted in such a way that the high-frequency resonance of the low-frequency track coincides with the low-frequency resonance of the high-frequency track,
characterized
in that two short reflectors (7, 11), respectively connected to one of the converters, are arranged between the input and output converters (2, 12) of each DMS track (A, B), the reflectors (3, 7, 11) of the input or output side being respectively interconnected electrically via conductor tracks (4, 8, 8).

2. Twin dual-mode filter according to Claim 1,
characterized
in that the short reflectors (7, 11) are replaced by fingers of suitable width.

3. Twin dual-mode filter according to Claim 1 or 2,
characterized
in that two twin dual-mode filters are connected in parallel.

4. Twin dual-mode filter according to Claim 1 or 2,
characterized by
two twin dual-mode filters with series-connected outputs.

5. Twin dual-mode filter according to Claim 1 or 2,
characterized by
two twin dual-mode filters with series-connected inputs and parallel-connected outputs.

6. Twin dual-mode filter according to Claims 1 to 5,
characterized
in that ohmic resistors (10) are connected in the supply leads to the input and output converters (2 and 12, respectively).

7. Twin dual-mode filter according to Claims 1 to 6,
characterized
in that the two reflectors (20, 21) arranged between the input and output converters (2, 12) of the low-frequency DMS track (B) and respectively connected to one of the converters (2, 12) are constructed with fingers inclined towards the direction of propagation of the surface acoustic waves.

8. Twin dual-mode filter according to Claims 1 to 7,
characterized
in that the terminal elements (5) of the filter input and filter output are applied without crossing to the mutually averted substrate surfaces of the DMS tracks (A, B).

## Revendications

1. Filtre bimode jumelé, comportant deux filtres DMS branchés par l'intermédiaire de lignes conductrices (4) avec pour chaque piste DMS (A, B) deux convertisseurs digités normaux (2, 12) actifs respectivement comme convertisseur d'entrée et convertisseur de sortie à l'intérieur de réflecteurs (3), les pistes DMS étant déphasées en fréquence l'une par rapport à l'autre de telle sorte que la résonance haute fréquence de la piste basse fréquence tombe sur la résonance basse fréquence de la piste haute fréquence,
caractérisé par le fait que deux réflecteurs courts (7, 11) et branchés chacun avec l'un des convertisseurs sont montés entre les convertisseurs d'entrée et de sortie (2, 12) de chaque piste DMS (A, B), les réflecteurs (3, 7, 11) du côté entrée ou du côté sortie étant à chaque fois reliés électriquement entre eux par l'intermédiaire de lignes conductrices (4, 8, 8).

2. Filtre bimode jumelé selon la revendication 1,
caractérisé par le fait que les réflecteurs courts (7, 11) sont remplacés par des doigts de largeur appropriée.

3. Filtre bimode jumelé selon la revendication 1 ou 2,
caractérisé par le fait que deux filtres bimode jumelés sont branchés en parallèle.

4. Filtre bimode jumelé selon la revendication 1 ou 2,
caractérisé par deux filtres bimode jumelés avec des sorties branchées en série.

5. Filtre bimode jumelé selon la revendication 1 ou 2,
caractérisé par deux filtres bimode jumelés avec des entrées branchées en série et des sorties branchées en parallèle.

6. Filtre bimode jumelé selon la revendication 1 à 5,
caractérisé par le fait que des résistances ohmiques (10) sont branchées dans les lignes d'amenée aux convertisseurs d'entrée et de sortie (2 ou 12).

7. Filtre bimode jumelé selon la revendication 1 à 6,
caractérisé par le fait que les deux réflecteurs (20, 21) montés entre les convertisseurs d'entrée et de sortie (2, 12) de la piste DMS basse fréquence (B) et branchés chacun à l'un des convertisseurs (2 ou 12) sont conçus avec des doigts inclinés par rapport à la direction de propagation des ondes de surface.

8. Filtre bimode jumelé selon la revendication 1 à 7,
caractérisé par le fait que les éléments de raccordement (5) de l'entrée de filtre et de la sortie de filtre sont appliqués sans croisement sur les surfaces de substrat, à l'opposé l'une de l'autre, des pistes DMS (A, B).
